Europäisches Patentamt

European Patent Office

Office européen des brevets

(19)

(11) Veröffentlichungsnummer: **0 005 762**
**B1**

(12) **EUROPÄISCHE PATENTSCHRIFT**

(45) Veröffentlichungstag der Patentschrift:
**30.12.81**

(51) Int. Cl.³: **H 01 L 21/90,** H 01 L 23/52,
G 01 R 31/28

(21) Anmeldenummer: **79101504.3**

(22) Anmeldetag: **16.05.79**

(54) **Verfahren zum Einprägen einer Spannung mit einem Elektronenstrahl.**

(30) Priorität: **02.06.78 DE 2824308**

(43) Veröffentlichungstag der Anmeldung:
**12.12.79 Patentblatt 79/25**

(45) Bekanntmachung des Hinweises auf die Patenterteilung:
**30.12.81 Patentblatt 81/52**

(84) Benannte Vertragsstaaten:
**FR GB NL**

(56) Entgegenhaltungen:
**FR-A-2 024 592**

**IBM TECHNICAL DISCLOSURE BULLETIN,
Vol. 17, Nr. 1, Juni 1974
New York, USA,
B.D. CHASE: "Pinhole detection in oxide layers on
integrated cirsuits", Seiten 235–236**

(73) Patentinhaber: **SIEMENS AKTIENGESELLSCHAFT Berlin
und München, Postfach 22 02 61, D-8000 München 22 (DE)**

(72) Erfinder: **Feuerbaum, Hans-Peter, Dipl.-Phys.,
Germersheimer Strasse 38, D-8000 München 80 (DE)**

ACTORUM AG.

Verfahren zum Einprägen einer Spannung mit einem Elektronenstrahl

Die Erfindung bezieht sich auf ein Verfahren zum Einprägen einer Spannung in ein elektronisches Bauelement einer integrierten Schaltung, die mit einer Passivierungsschicht aus elektrisch isolierendem Material versehen ist, mit einem Elektronenstrahl.

Ein Elektronenstrahl kann bekanntlich zur berührungslosen Prüfung der Funktion von elektronischen Bauelementen, insbesondere von integrierten Schaltkreisen, verwendet werden. Zu diesem Zweck wird der integrierte Schaltkreis in die Probenkammer eines Rasterelektronenmikroskops eingesetzt. Der Primärelektronenstrahl löst an der Oberfläche des Bauelements Sekundärelektronen aus, deren Energie mit einem Spektrometer gemessen werden kann.

Zur Prüfung solcher Bauelemente können Spannungen von aussen eingeprägt werden. Zu diesem Zweck werden mechanische Spitzen auf leitende Bereiche des Bauelements aufgesetzt.

Es ist aber üblich, bei solchen Bauelementen mit einem Grundkörper aus Halbleitermaterial die Oberfläche zur Passivierung mit einer Schicht aus elektrisch isolierendem Material, beispielsweise Siliziumoxid SiO oder Siliziumdioxid $SiO_2$, zu versehen. Durch diese Passivierungsschicht werden die elektrisch leitenden Bereiche abgedeckt und können somit von einer mechanischen Spitze ohne Zerstörung der Oberflächenschicht nicht mehr erreicht werden.

Mit dem Primärelektronenstrahl eines Rasterelektronenmikroskops ist bekanntlich die Injektion von Ladungen in die Oberfläche der isolierenden Passivierungsschicht möglich. Diese Injektion von Ladungsträgern in den Isolator kann zur Analyse von Leckströmen verwendet werden («Scanning Electron Microscopy» – Part IV — IITRI, Chicago/USA, SEM, April 1976, Seiten 515 bis 520). Ein Eingriff in das elektrische Verhalten der Schaltung ist damit jedoch nicht möglich.

Der Erfindung liegt nun die Aufgabe zugrunde, in elektronische Bauelemente mit einer Passivierungsschicht aus elektrisch isolierendem Material Spannungen einzuprägen.

Diese Aufgabe wird erfindungsgemäss dadurch gelöst, dass die Passivierungsschicht wenigstens teilweise mit einem Metallfilm versehen wird, der an eine Versorgungsspannung angeschlossen wird und auf den der Elektronenstrahl gerichtet wird. Die Beschleunigungsspannung wird so gewählt, dass er innerhalb der Passivierungsschicht eine Diffusionswolke aufbaut, und dass diese Diffusionswolke durch ihre strahlinduzierte Leitfähigkeit das Bauelement mit dem Metallfilm elektrisch leitend verbindet. Der Elektronenstrahl dient somit lediglich als Schalter zum Kurzschliessen und zum Herstellen der leitenden Verbindung zwischen dem Metallfilm und dem leitenden Bereich, beispielsweise einer Leiterbahn des integrierten Schaltkreises. Durch die eingeprägte Spannung erhält man in einfacher Weise eine Information über die Funktion und Wirkungsweise des Bauelements sowie über vorhandene Fehler, beispielsweise eine Unterbrechung in der Leiterbahn des Bauelements.

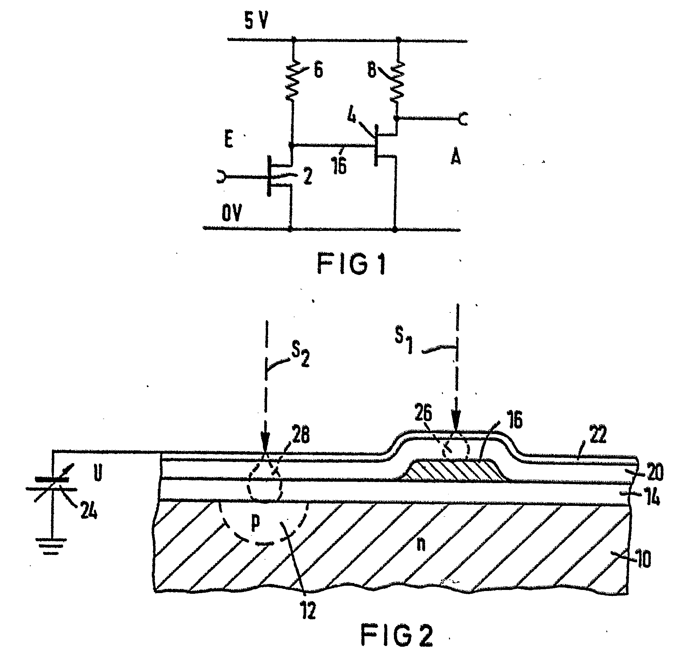

Zur weiteren Erläuterung der Erfindung wird auf die Zeichnung Bezug genommen, in deren Figur 1 die Schaltung eines elektronischen Bauelements schematisch veranschaulicht ist. Figur 2 zeigt einen Schnitt durch den Aufbau eines Teils der Figur 1.

Nach Figur 1 enthält eine Verstärkerschaltung zwei Transistoren 2 und 4, die zur Verstärkung in Kaskade geschaltet sind und jeweils in Reihe mit einem Lastwiderstand 6 bzw. 8 zwischen einer Versorgungsspannung von beispielsweise 5 V und Nullpotential angeordnet sind. Der Eingang ist mit E und der Ausgang mit A bezeichnet. Eine den Laststrom führende Hauptelektrode des Transistors 2 ist über einen Verbindungsleiter 16 mit der Steuerelektrode des Transistors 4 verbunden. In der praktischen Ausführungsform kann die Verstärkerschaltung beispielsweise ein Teil eines integrierten Schaltkreises sein, der den Verbindungsleiter 16 als Leiterbahn enthält.

Zur Prüfung der Funktion des integrierten Schaltkreises soll nach Figur 2 in diese Leiterbahn 16 eine Spannung von aussen eingeprägt werden, die dann als Steuerspannung für den Transistor 4 dient und am Ausgang A das verstärkte Signal erscheinen lässt, solange die Leiterbahn 16 oder weitere Anschlussleiter des Transistors 4 keine Unterbrechung enthalten.

Nach Figur 2 ist die in Figur 1 dargestellte Verstärkerschaltung auf einem Grundkörper 10 aus Halbleitermaterial, beispielsweise n-leitendem Silizium, angeordnet. Der Halbleiterkörper 10 enthält einen p-leitenden Bereich 12, der beispielsweise durch Diffusion von p-leitendem Dotierungsstoff hergestellt sein kann und die Funktion eines Widerstands oder einer Leiterbahn innerhalb der integrierten Schaltung haben kann. Die Oberfläche des Halbleiterkörpers 10 ist mit einer Oxidschicht 14 versehen, die als Schutzschicht dient und beispielsweise aus Siliziumoxid SiO oder Siliziumdioxid $SiO_2$ mit einer Dicke von beispielsweise etwa 1 µm bestehen kann. Auf dieser Schutzschicht 14 ist die Leiterbahn 16 des Verstärkers angeordnet. Die Oberfläche des Bauelements ist mit einer Isolatorschicht mit einer Dicke von beispielsweise ebenfalls etwa 1 µm versehen, die als Passivierungsschicht 20 dient und einen Schutz gegen mechanische Beschädigung sowie einen Korrosionsschutz für die Leiterbahnen, beispielsweise die Leiterbahn 16, des Bauelements darstellt.

Die Passivierungsschicht 20 wird wenigstens teilweise mit einem Metallfilm 22 als Abdeckung versehen, der vorzugsweise aus Aluminium oder auch aus Gold bestehen kann und zweckmässig aufgedampft wird. Die Dicke des Metallfilms 22 wird so bemessen, dass einerseits seine Leitfähigkeit ausreicht, um den Spannungsabfall innerhalb des Films zu begrenzen, und dass man andererseits eine ausreichende Eindringtiefe des Elektronenstrahls in das Bauelement erhält. Die Dicke kann deshalb etwa eine Grössenordnung geringer als die Dicke der Passivierungsschicht 20 sein und beispielsweise 0,1 µm betragen. Der Metallfilm 22 ist mit einer Spannungsquelle 24 elektrisch leitend verbunden, die eine in elektrisch leitende Bereiche des Bauelements einzuprägende Spannung U liefert. Diese Spannung U sol beispielsweise mit dem Primärelektronenstrahl $S_1$ eines Rasterelektronenmikroskops in die Leiterbahn 16 eingeprägt werden. Zu diesem Zweck wird der Primärelektronenstrahl $S_1$ mit einer Beschleunigungsspannung der Primärelektronen von beispielsweise $U_{PE} = 10$ kV auf den Metallfilm 22 oberhalb der Leiterbahn 16 gerichtet. Durch die Primärelektronen entsteht in der Passivierungsschicht 22 eine Diffusionswolke 26. Die Elektronen diffundieren nach allen Richtungen und setzen Elektronenlochpaare frei. Das Oxid wird elektrisch leitend und bildet dadurch zwischen der Leiterbahn 18 und dem Metallfilm 22 eine elektrisch leitende Verbindung. Die Spannung U wird somit in die Leiterbahn 16 eingeprägt, und es kann geprüft werden, ob das Bauelement auf diese eingeprägte Spannung reagiert.

Ferner ist eine Kontaktierung des Metallfilms 22 mit dem Diffusionsgebiet des Bereichs 12 möglich. Zu diesem Zweck müssen die Primärelektronen die beiden Isolierungsschichten 14 und 20 durchdringen. Es wird deshalb ein Primärelektronenstrahl $S_2$ mit einer entsprechend höheren Beschleunigungsspannung von beispielsweise $U_{PE} = 15$ kV auf den Metallfilm 22 oberhalb der Elektrode 14 gerichtet. Eine entsprechende Diffusionswolke 28 bildet sich in den beiden Isolationsschichten und erreicht das Diffusionsgebiet des Bereichs 12. Die externe Spannung U wird somit durch die innerhalb der Diffusionswolke 28 entstehende strahlinduzierte Leitfähigkeit in die leitenden Bereiche des Bauelements eingeprägt, und der Elektronenstrahl $S_1$ bzw. $S_2$ dient lediglich als Schalter. Er erzeugt die lokale strahlinduzierte Leitfähigkeit und bewirkt damit den elektrischen Kontakt zwischen dem Metallfilm 22 und dem entsprechenden Bauelement des integrierten Schaltkreises.

## Patentanspruch

Verfahren zum Einprägen einer Spannung in ein elektronisches Bauelement einer integrierten Schaltung, die mit einer Passivierungsschicht aus elektrisch isolierendem Material versehen ist, mit einem Elektronenstrahl, dadurch gekennzeichnet, dass die Passivierungsschicht (20) wenigstens teilweise mit einem Metallfilm (22) versehen wird, der an eine Versorgungsspannung (U) angeschlossen wird und auf den der Elektronenstrahl ($S_1$, $S_2$) gerichtet wird, dessen Beschleunigungsspannung so gewählt wird, dass er innerhalb der Passivierungsschicht (20 bzw. 14, 20) eine Diffusionswolke (26 bzw. 28) aufbaut und dass diese Diffusionswolke (26 bzw. 28) durch ihre strahlinduzierte Leitfähigkeit das Bauelement (10, 14, 16, 20 bzw. 10, 12, 14, 20) mit dem Metallfilm (22) elektrisch leitend verbindet.

## Claim

1. A method of impressing a voltage into an electronic component of an integrated circuit, which is provided with a passivation layer made of an electrically insulating material, by means of an electron beam, characterised in that the passivation layer (20) is at least partially provided with a metal film (22) which is connected to a supply voltage (U) and towards which the electron beam ($S_1$, $S_2$) is pointed, the accelerating voltage of the electron beam being so selected that the beam creates a diffusion cloud (26 and 28) within the passivation lyer (20 and 14, 20) and that this diffusion cloud (26 and 28) electrically conductively connects the component (10, 14, 16, 20 and 10, 12, 14, 20) to the metal film (22) by means of its conductivity induced by the beam.

## Revendication

Procédé pour appliquer une tension à un composant électronique d'un circuit intégré pourvu d'une couche de passivation en une matière isolante du point de vue électrique, à l'aide d'un faisceau d'électrons, caractérisé en ce que la couche (20) de passivation est munie au moins en partie d'une pellicule (22) métallique, qui est raccordée à une tension (U) d'alimentation et sur laquelle est dirigé le faisceau ($S_1$, $S_2$) d'électrons dont la tension d'accélération est telle qu'il se crée, à l'intérieur de la couche (20 et 14, 20) de passivation un nuage (26 et 28) de diffusion et que ce nuage (26 et 28) de diffusion, par sa conductivité induite par le faisceau, relie de manière conductrice du point de vue électrique le composant (10, 14, 16, 20 et 10, 12, 14, 20) à la pellicule (22) métallique.

0 005 762

FIG 1

FIG 2